**Europäisches Patentamt**

**European Patent Office**

**Office européen des brevets**

(11) Veröffentlichungsnummer: **0 520 590 A1**

# EUROPÄISCHE PATENTANMELDUNG

(21) Anmeldenummer: **92201923.7**

(22) Anmeldetag: **29.06.92**

(51) Int. Cl.5: **H03L 7/191**, H03L 7/087

(30) Priorität: **28.06.91 DE 4121361**

(43) Veröffentlichungstag der Anmeldung:
**30.12.92 Patentblatt 92/53**

(84) Benannte Vertragsstaaten:
**DE FR GB IT**

(71) Anmelder: **Philips Patentverwaltung GmbH**
**Wendenstrasse 35 Postfach 10 51 49**
**W-2000 Hamburg 1(DE)**

(84) **DE**

(71) Anmelder: **N.V. Philips' Gloeilampenfabrieken**

**Groenewoudseweg 1**
**NL-5621 BA Eindhoven(NL)**

(84) **FR GB IT**

(72) Erfinder: **Wünsch, Christian**
**c/o Philips Patentverwaltung GmbH**
**Wendenstr. 35**
**W-2000 Hamburg 1(DE)**

(74) Vertreter: **Volmer, Georg et al**
**Philips Patentverwaltung GmbH**
**Wendenstrasse 35, Postfach 10 51 49**
**W-2000 Hamburg 1(DE)**

(54) **Schaltungsanordnung zur Frequenzsynthese.**

(57) Die Erfindung bezieht sich auf eine Schaltungsanordnung zur Frequenzsynthese mit einem Phasenregelkreis (1), der einen ersten Phasendiskriminator (3) zum Empfang eines Referenzsignals und eines von einem ersten Frequenzteiler (6) mit einem Teilungsverhältnis von k gelieferten Ausgangssignals, einen mit dem Ausgang des ersten Phasendiskriminator (3) gekoppelten Tiefpaß (4) und einen mit dem Ausgang des Tiefpasses (4) gekoppelten Oszillator (5) zur Erzeugung eines dem ersten Frequenzteiler (6) zuführbaren Ausgangssignals enthält. Mindestens ein weiterer Zweig (2) mit einem weiteren Phasendiskriminator (8) und einem weiteren freizugebenden Frequenzteiler (9) mit einem Teilungsverhältnis von k ist enthalten. Der weitere mit dem Eingang des Tiefpasses (4) gekoppelte Phasendiskriminator (8) ist zum Empfang des von einem Verzögerungsglied (10) verzögerten Referenzsignals und des Ausgangssignals des weiteren zum Empfang des Ausgangssignals des Oszillators (5) vorgesehenen Frequenzteilers (9) eingerichtet. Jedes Verzögerungsglied (10) weist eine unterschiedliche, einer Teilperiode $T = 1/(n * f_{ref})$ des Referenzsignals entsprechende Verzögerungszeit auf, wobei n die Anzahl der Zweige (1, 2) und $f_{ref}$ die Frequenz des Referenzsignals ist. Eine Steuerung (11) ist zur Freigabe der Frequenzteiler (9) ungefähr nach der Verzögerungszeit des dem jeweiligen Frequenzteiles (9) zugeordneten Verzögerungsgliedes (10) vorgesehen.

FIG.1

Die Erfindung bezieht sich auf eine Schaltungsanordnung zur Frequenzsynthese mit einem Phasenregelkreis, der einen ersten Phasendiskriminator zum Empfang eines Referenzsignals und eines von einem ersten Frequenzteiler mit einem Teilungsverhältnis von k gelieferten Ausgangssignals, einen mit dem Ausgang des ersten Phasendiskriminator gekoppelten Tiefpaß und einen mit dem Ausgang des Tiefpasses gekoppelten Oszillator zur Erzeugung eines dem ersten Frequenzteiler zuführbaren Ausgangssignals enthält.

Eine solche Schaltungsanordnung, bestehend aus einem spannungsgesteuerten Oszillator, einem Tiefpaß, einem variierbaren digitalen Frequenzteiler, einem Phasendiskriminator und einem stabilen Vergleichsoszillator, der die Referenzfrequenz bereitstellt, eignet sich insbesondere zur indirekten Frequenzsynthese. Hierbei bringt der Frequenzteiler die Frequenz des Ausgangssignals des Oszillators in die Größenordnung des Vergleichsoszillators und der Phasendiskriminator sendet Steuerimpulse in Abhängigkeit des Phasen- oder Frequenzfehlers dem Tiefpaß, der diese in eine Steuerspannung umformt, höherfrequente Anteile unterdrückt und die Steuerspannung dem Oszillator zugeführt. Hierdurch wird der Oszillator in Phase und Frequenz geregelt, so daß dieser die Langzeitstabilität und mit Einschränkungen auch die Kurzzeitstabilität des Vergleichsoszillators annimmt.

Einfache Schaltungsanordnungen dieser Art, welche im Rückführungspfad veränderliche Frequenzteiler mit ganzzahligen Teilungsfaktoren haben, besitzen einige Nachteile. So ist die Frequenz des Ausgangssignals des Oszillators ein ganzzahliges Vielfaches der Frequenz des Referenzsignals, was bei oft gewünschten kleinen Frequenzschritten zu niedrigen Referenzfrequenzen zwingt, insbesondere bei feinem Frequenzraster des Ausgangssignals des Oszillators. Größer werdende Teilungsfaktoren bewirken eine zunehmende Verschlechterung des Phasenrauschens der Frequenz des Ausgangssignals des Oszillators innerhalb der Regelbandbreite. Weiterhin erzwingen kleine Frequenzen des Referenzsignals kleine Regelbandbreiten, was die Regelschleife langsam werden läßt und somit werden schnelle Frequenzwechsel, wie sie immer häufiger benötigt werden, bei kleinen gewünschten Frequenzschritten mit dieser Technik unmöglich.

Zur Beseitigung dieses Konfliktes sind mehrere Lösungen bekannt. So werden mehrere Phasenregelkreise über Mischer miteinander verkoppelt, so daß die die Eigenschaften hauptsächlich bestimmende Schleife mit einer relativ hohen Frequenz des Referenzsignals arbeitet (Manassewitsch, V.: "Frequency Synthesizer", John Wiley & Sons, 1987, 3. Auflage, S. 308ff; EP-A1-0 393 975). Bei dieser Maßnahme wird durch die Einfügung der Mischer ein höherer hochfrequenztechnische Aufwand benötigt, da entsprechende Seitenbandfilter nötig werden.

Eine weitere Variante besteht in der Verwendung fraktionaler Frequenzteiler, mit denen es möglich ist die Frequenz des Ausgangssignals des Oszillators auf ein nichtganzzahliges Vielfaches der Frequenz des Referenzsignals zu setzen (US-Patent Nr. 3 959 737). Dabei wird das Teilungverhältnis des Frequenzteilers in einer solchen Rate zwischen K und K+1 geändert, daß im zeitlichen Mittel die gewünschte Frequenz des Ausgangssingals entsteht. Die Manipulation des Teilungsverhältnisses führt zu Phasenstörungen, die jedoch vorhersehbar sind, so daß sie dem jeweiligen Aufwand entsprechend mehr oder weniger unterdrückt werden können (Hersman, R.: "Durchbruch bei der rauscharmen Frequenzsynthese", elektronik industrie, Jahrgang 22, Heft 5, S. 32-37; WO 86/05045; DE-A1-35 44 371). Die dem Prinzip innewohnenden Phasenstörungen des Ausgangssignals des Oszillators müssen mit teilweise erheblichem Aufwand kompensiert werden.

Der Erfindung liegt die Aufgabe zugrunde, eine Schaltungsanordnung zur Frequenzsynthese der eingangs genannten Art zu schaffen, mit der die Regelgeschwindigkeit und das Phasenrauschen innerhalb der Regelbandbreite ohne Phasenregelkreise mit Mischer oder fraktionelle Teiler gegenüber einem einfachen Phasenregelkreis verbessert wird.

Diese Aufgabe wird durch eine Schaltungsanordnung der eingangs genannten Art dadurch gelöst, daß mindestens ein weiterer Zweig mit einem weiteren Phasendiskriminator und einem weiteren freizugebenden Frequenzteiler mit einem Teilungsverhältnis von k enthalten ist, daß der weitere mit dem Eingang des Tiefpasses gekoppelte Phasendiskriminator zum Empfang des von einem Verzögerungsglied verzögerten Referenzsignals und des Ausgangssignals des weiteren zum Empfang des Ausgangssignals des Oszillators vorgesehenen Frequenzteilers eingerichtet ist, daß jedes Verzögerungsglied eine unterschiedliche, einer Teilperiode $T = 1/(n * f_{ref})$ des Referenzsignals entsprechende Verzögerungszeit aufweist, wobei n die Anzahl der Zweige und $f_{ref}$ die Frequenz des Referenzsignals ist, und daß eine Steuerung zur Freigabe der Frequenzteiler ungefähr nach der Verzögerungszeit des dem jeweiligen Frequenzteiler zugeordneten Verzögerungsgliedes vorgesehen ist.

Bei der erfindungsgemäßen Schaltungsanordnung ist mindestens ein weiterer Zweig mit einem zweiten Phasendiskriminator und einem zweiten Teiler dem Phasenregelkreis (erster Zweig) hinzugefügt. Dem zweiten Phasendiskriminator wird das Referenzsignal verzögert zugeführt und der zweite Teiler wird nach einer bestimmten Verzögerungszeit freigegeben. Die Verzögerungszeit des Verzögerungsgliedes entspricht bei nur einem zweiten Zweig der halben Periode des Referenzsignals. Der zweite Teiler wird ungefähr nach der Verzögerungszeit des Verzögerungsgliedes freigegeben. Dann können erst die in der Frequenz geteilten Ausgangssignale des Oszillators zum zweiten Phasendiskriminator durchgelassen werden. Durch die erfindungsgemäßen Maßnahmen werden dem Tiefpaß und damit dem Oszillator mehr Steuerimpulse zugeführt. Daraus resultiert, daß die Regelgeschwindigkeit und das Phasenrauschen unter der Voraussetzung verbessert wird, daß die Frequenz des Referenzsignals und auch die Frequenzschrittweite gegenüber dem einfachen Phasenregelkreis beibehalten wird. Ein Phasenregelkreis mit Mischern und fraktionellen Teilern ist bei der Erfindung nicht erforderlich.

Werden beispielsweise vier Zweige verwendet, so beträgt die Verzögerungszeit des zweiten Verzögerungsgliedes ein Viertel der Periode des Referenzsignals, die Verzögerungszeit des dritten Verzögerungsgliedes die Hälfte der Periode und die Verzögerungszeit des vierten Zweiges drei Viertel der Periode des Referenzsignals. Die zweiten bis vierten Zweige enthalten jeweils einen Phasendiskriminator und einen Frequenzteiler. Der erste Phasendiskriminator, der Tiefpaß, der Oszillator und der erste Frquenzteiler bilden den ersten Zweig. Jedes Verzögerungsglied weist also eine unterschiedliche Verzögerungszeit auf. Die Verzögerungszeit berechnet sich aus einer Teilperiode $T = 1/(n * f_{ref})$. n ist dabei die Anzahl der Zweige und $f_{ref}$ die Frequenz des Referenzsignals. Der erste Zweig wird also überhaupt nicht verzögert, der zweite Zweig um eine Teilperiode, der dritte Zweig um zwei Teilperioden und der n-te Zweig um n Teilperioden. Eine Periode des Referenzsignals ist als die Dauer eines Impulses und einer Impulspause definiert. Die Frequenzteiler der weiteren Zweige werden ungefähr nach der Verzögerungszeit des dem jeweiligen Frequenzteilers zugeordneten Verzögerungsgliedes entsprechend freigegeben.
Bei einer digitalen Ausführung der Schaltungsanordnung zur Frequenzsynthese ist vorgesehen, daß ein Frequenzteiler wenigstens einen Zähler enthält. Der maximale Zählerstand eines solchen Teilers entspricht dem Teilungsverhältnis k. Werden variierbare Frequenzteiler eingesetzt, so läßt sich dieser Zählerstand beliebig einstellen.

In einer Weiterbildung der Steuerung ist vorgesehen, daß diese wenigstens einen Komparator zur Erzeugung eines Freigabesignals für den zugeordneten Frequenzteiler enthält. Das Freigabesignal wird erzeugt, wenn der Inhalt des Zählers im Frequenzteiler einen vorgebbaren Wert übersteigt. Bei zwei Zweigen entspricht dieser vorgebbare Wert der Hälfte des Teilungsverhältnisses k.

In einer weiteren einfachen Ausführungsform der Steuerung bei zwei Zweigen mit zwei Phasendiskriminatoren ist vorgesehen, daß diese zwei D-Kippglieder enthält, daß der Takteingang des ersten D-Kippgliedes das Referenzsignal und der Takteingang des zweiten D-Kippgliedes das verzögerte Referenzsignal enthält, daß ein Ausgang des ersten D-Kippgliedes mit dem D-Eingang des zweiten D-Kippgliedes gekoppelt ist und daß ein Ausgang des zweiten D-Kippgliedes das Freigabesignal liefert.

Zur Verringerung des Phasenrauschens ist vorgesehen, daß die Phasendiskriminatoren über einen Wechselschalter mit dem Tiefpaß gekoppelt sind. Hierbei ist jeweils nur ein Phasendiskriminator mit dem Tiefpaß gekoppelt. Gesteuert werden kann der Wechselschalter mit Hilfe der den Phasendiskriminatoren zugeführten Referenzsignale.

Der Aufwand für die Frequenzteiler kann reduziert werden, wenn die Frequenzteiler sich durch mindestens zwei in Reihe geschaltete Frequenzteiler realisieren lassen. Dabei ist vorgesehen, daß der Ausgang des Oszillators mit einem Eingang eines Hilfsfrequenzteilers gekoppelt ist, dessen Ausgang mit den Eingängen der Frequenzteiler gekoppelt ist. Das Teilungsverhältnis der Frequenzteiler muß mindestens gleich der Anzahl der Zweige der Schaltungsanordnung zur Frequenzsynthese sein.

Ausführungsbeispiele der Erfindung werden nachstehend anhand der Figuren näher erläutert. Es zeigen:

Fig. 1     ein erstes schematisch dargestelltes, allgemein gehaltenes Ausführungsbeispiel der Schaltungsanordnung zur Frequenzsynthese,

Fig. 2     ein weiteres Ausführungsbeispiel der Schaltungsanordnung zur Frequenzsynthese mit zwei Zweigen,

Fig. 3     das Ausführungsbeispiel der Schaltungsanordnung nach Fig. 2 mit einem Wechselschalter,

Fig. 4     das Ausführungsbeispiel der Schaltungsanordnung nach Fig. 2 mit einer detaillierter dargestellten Steuerung und

Fig. 5     ein Ausführungsbeispiel der Schaltungsanordnung nach Fig. 2 mit einem Hilfsfrequenzteiler.

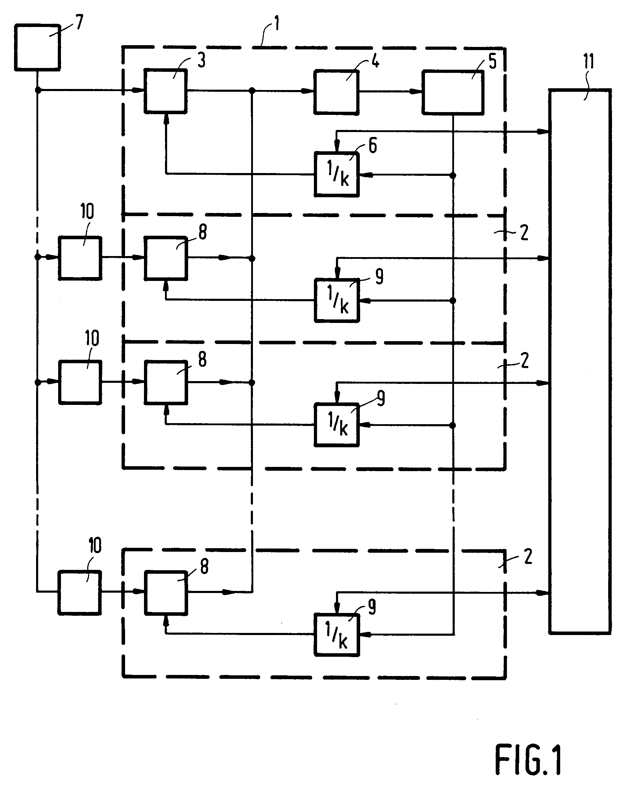

Das erste allgemein gehaltene Ausführungsbeispiel der erfindungsgemäßen Schaltungsanordnung zur Frequenzsynthese in Fig. 1 enthält einen ersten Zweig 1 und weitere n-1 Zweige 2. Der erste Zweig 1 umfaßt einen Phasendiskriminator 3, einen Tiefpaß 4, einen spannungsgesteuerten Oszillator 5 und einen gegebenenfalls einstellbaren Frequenzteiler 6 mit einem Teilungsfaktor k. Der Phasendiskriminator 3 erhält ein Referenzsignal von einem Referenzoszillator 7 und das Ausgangssignal des Frequenzteilers 6. Das Ausgangssignal des Phasendiskriminators 3 wird über den Tiefpaß 4 dem spannungsgesteuerten Oszillator 5 zugeführt. In den weiteren Zweigen 2 ist jeweils ein weiterer Phasendiskriminator 8 und ein weiterer Frequenzteiler 9 enthalten. Der jeweilige Phasendiskriminator 8 erhält über ein Verzögerungsglied 10 das Referenzsignal und vergleicht dieses mit dem von dem jeweiligen Frequenzteiler 9 gelieferten Ausgangssignal. Der Ausgang jedes Phasendiskriminators 8 ist mit dem Eingang des Tiefpasses 4 verbunden. Der Ausgang des Oszillators 5 ist mit dem Eingang der Frequenzteiler 6 und 9 gekoppelt. Den jeweiligen Verzögerungsgliedern 10 wird noch das Referenzsignal von dem Referenzoszillator 7 zugeführt.

Eine Steuerung 11 ist vorhanden, welche die Frequenzteiler 9 freigibt, damit das vom Oszillator gelieferte Ausgangssignal in der Frequenz geteilt den Phasendiskriminatoren 8 zugeführt werden kann. Jedes Verzögerungsglied 10 weist eine unterschiedliche einer Teilperiode des Referenzsignals entsprechende Verzögerungszeit auf. Jede Periode des Referenzsignals ist in n Teilperioden eingeteilt. n ist die Anzahl der vorhandenen Zweige 1 und 2. Eine Teilperiode läßt sich nach der folgenden Formel berechnen: $T = 1/(n * f_{ref})$, wobei $f_{ref}$ die Frequenz des Referenzsignals ist. So wird ein erstes Verzögerungsglied 10 das vom Referenzoszillator 7 erhaltene Referenzsignal um eine Teilperiode, ein weiteres Verzögerungsglied um zwei Teilperioden und das Verzögerungsglied 10 im n-ten Zweig um n-1 Teilperioden verzögern. Freigegeben werden die Frequenzteiler 9, die ebenfalls ein Teilungsverhältnis k aufweisen, ungefähr nach der Verzögerungszeit des dem jeweiligen Frequenzteiler 9 zugeordneten Verzögerungsgliedes. Die Steuerung 11 gibt also die Frequenzteiler 9 nacheinander in den Abständen von ungefähr einer Teilperiode frei.

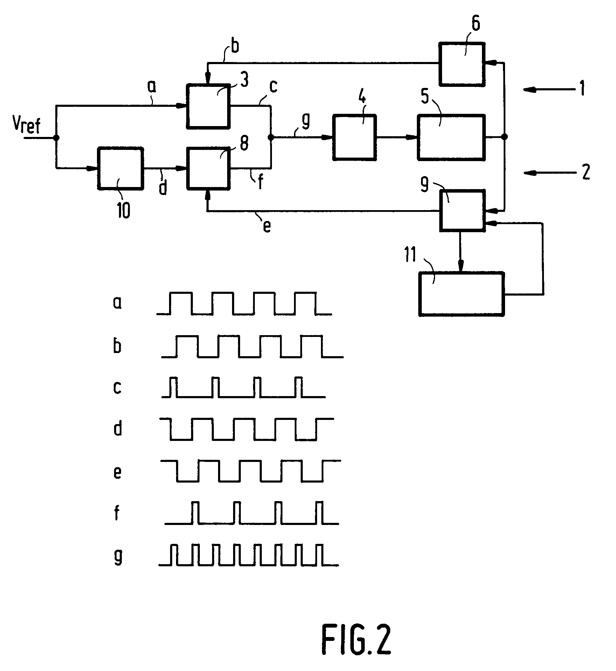

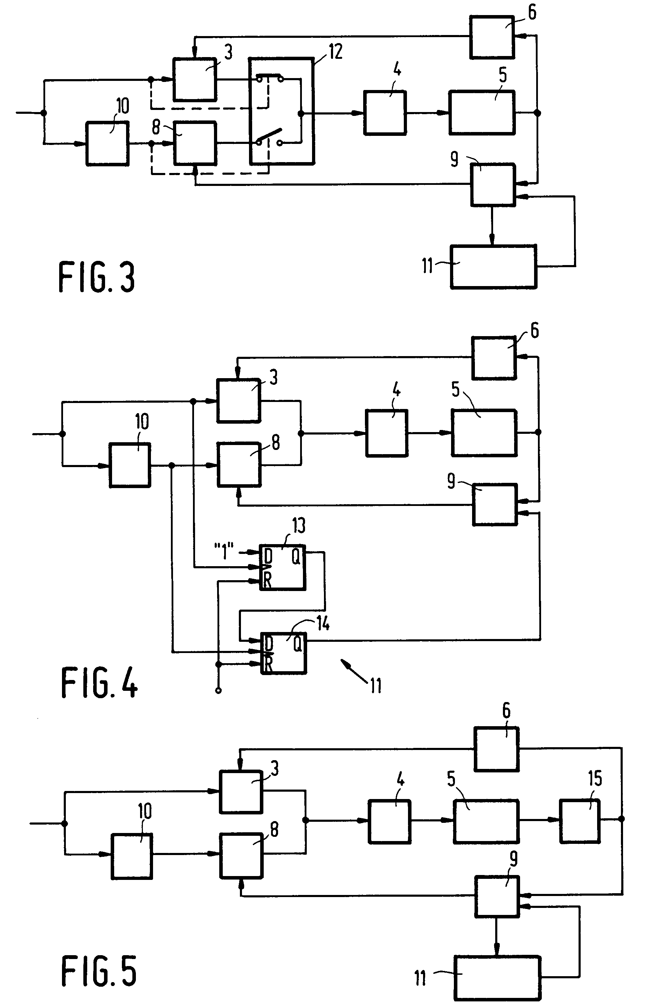

Zur Erläuterung der Funktionsweise des Ausführungsbeispiels nach Fig. 1 wird im folgenden die in Fig. 2 dargestellte Schaltungsanordnung mit zwei Zweigen erläutert. Der erste Zweig der Schaltungsanordnung nach Fig. 4 enthält im ersten Zweig 1 ebenfalls den Phasendiskriminator 3, den Tiefpaß 4, den Oszillator 5 und den Frequenzteiler 6. Der zweite Zweig enthält einen Phasendiskriminator 8 und einen Frequenzteiler 9. Die Frequenzteiler 6 und 9 können als Zähler realisiert sein, denen extern das Teilungsverhältnis k als maximaler Zählerwert zuführbar ist. Vor dem Phasendiskriminator 8 ist noch das Verzögerungsglied 10 geschaltet. Das Referenzsignal $U_{ref}$ wird dem Phasendiskriminator 3 und den Verzögerungsgliedern 10 geliefert. Dieses Signal und die folgenden Signale sind detaillierter in dem nebenstehenden Zeitdiagramm der Fig. 2 dargestellt. Das Referenzsignal $U_{ref}$ wird in diesem Zeitdiagramm als Signal a bezeichnet. Von dem Frequenzteiler 6 wird das Signal b geliefert. Hieraus bildet der Phasendiskriminator 3 das Signal c, welches über den Tiefpaß dem Oszillator 5 zugeführt wird. In dem Verzögerungsglied 10 wird das Referenzsignal $U_{ref}$ um eine halbe Periode verzögert. Das Ausgangssignal des Verzögerungsglieds 10 ist als Signal d in dem Zeitdiagramm dargestellt. Dieses wird auf den Phasendiskriminator 8 gegeben, der daraus das Signal f bildet. Als weiteres Signal erhält der Phasendiskriminator 8 noch das Signal e von dem Frequenzteiler 9. Die sich überlagernden Signale c und f ergeben das Signal g, das dem Tiefpaß 4 zugeführt wird. Wie sich aus dem Zeitdiagramm ergibt, ist eine doppelte Anzahl von Steuerimpulsen für den Tiefpaß 4 im Signal g enthalten. Hierdurch wird das Phasenrauschen und die Regelzeit gegenüber einem Tiefpaß mit nur einer Schleife verbessert. Die Steuerung 11 gibt noch nach einer halben Periode des Referenzsignals den Teiler 9 frei, der danach ein Ausgangssignals erzeugt, welches dem Phasendiskriminator 8 zugeführt wird. Diese Freigabe wird beim Start oder beim Frequenzwechsel (Teilerverhältnis k wird verändert) der erfindungsgemäßen Schaltungsanordnung durchgeführt.

Die Steuerung 11 in der Fig. 2 kann einen Komparator aufweisen, der den Inhalt des durch einen Zähler realisierten Frequenzteilers 9 mit der Hälfte des Teilungsverhältnisses k vergleicht. Übersteigt der Zählerinhalt des Frequenzteilers 9 das Verhältnis k/2, dann wird ein Freigabesignal für den Frequenzteiler 9 erzeugt.

Das Ausführungsbeispiel der Fig. 3 zeigt noch gegenüber dem Ausführungsbeispiel der Fig. 2 einen zusätzlichen Wechselschalter 12, der die Ausgangssignale der Phasendiskriminatoren 3 und 8 empfängt und ein Eingangssignal dem Tiefpaß zuführt. Dieser Wechselschalter 12 führt wechselweise das Ausgangssignal des Phasendiskriminators 3 und des Phasendiskriminators 8 zum Tiefpaß 4. Gesteuert werden kann dieser Wechselschalter 12 beispielsweise durch die positive Flanke des Referenzsignals und des verzögerten Referenzsignals. Geöffnet werden die Schalter im Wechselschalter 12 jeweils durch eine negative Flanke des Referenzsignals und des verzögerten Referenzsignals.

Das Ausführungsbeispiel der Fig. 4 ist gegenüber dem Ausführungsbeispiel der Fig. 2 durch eine detaillierter dargestellte Steuerung 11 verändert. Die Steuerung 11 enthält zwei D-Kippglieder 13 und 14. Der Takteingang des ersten D-Kippgliedes 13 ist mit dem Eingang des Phasendiskriminators 3 verbunden und der Takteingang des zweiten D-Kippgliedes 14 ist mit dem Eingang des Phasendiskriminators 8 verbunden. Dem D-Eingang des ersten D-Kippgliedes 13 wird noch eine logische "1" zugeleitet. Der nichtinvertierende Ausgang (Q) des D-Kippgliedes 13 ist an den D-Eingang des zweiten D-Kippgliedes 14 angeschlossen. Mit der abfallenden Flanke des Signales a (Fig. 2) wird der Frequenzteiler 9 freigegeben. Das Freigabesignal weist in diesem Fall eine logische "1" auf. Vor der Freigabe sollten die beiden D-Kippglieder 13 und 14 durch ein von außen zuführbares Signal an ihre Rücksetz-Eingänge zurückgesetzt werden. Die bei diesem Ausführungsbeispiel eingesetzten Frequenzteiler 6 und 9 sind nicht einstellbar.

Das Ausführungsbeispiel der Fig. 5 unterscheidet sich gegenüber dem Ausführungsbeispiel der Fig. 2 noch durch einen zusätzlichen Hilfsfrequenzteiler 15. Dieser Hilfsfrequenzteiler 15 kann das Ausgangssignal des Oszillators 5 in der Frequenz teilen bevor dieses den Frequenzteilern 6 und 9 zugeführt wird. Die Frequenzteiler 6 und 9 können dadurch mit geringerem Aufwand realisiert werden. Das Verhältnis k der Frequenzteiler 6 und 9 darf allerdings nicht kleiner sein als die Anzahl der Zweige der Schaltungsanordnung. Bei dem vorliegenden Beispiel muß das Teilungsverhältnis der Frequenzteiler 6 und 9 also mindestens gleich 2 sein.

**Patentansprüche**

1. Schaltungsanordnung zur Frequenzsynthese mit einem Phasenregelkreis (1), der
   - einen ersten Phasendiskriminator (3) zum Empfang eines Referenzsignals und eines von einem ersten Frequenzteiler (6) mit einem Teilungsverhältnis von k gelieferten Ausgangssignals,
   - einen mit dem Ausgang des ersten Phasendiskriminator (3) gekoppelten Tiefpaß (4) und
   - einen mit dem Ausgang des Tiefpasses (4) gekoppelten Oszillator (5) zur Erzeugung eines dem ersten Frequenzteiler (6) zuführbaren Ausgangssignals enthält,
   dadurch gekennzeichnet,
   daß mindestens ein weiterer Zweig (2) mit einem weiteren Phasendiskriminator (8) und einem weiteren freizugebenden Frequenzteiler (9) mit einem Teilungsverhältnis von k enthalten ist,
   daß der weitere mit dem Eingang des Tiefpasses (4) gekoppelte Phasendiskriminator (8) zum Empfang des von einem Verzögerungsglied (10) verzögerten Referenzsignals und des Ausgangssignals des weiteren zum Empfang des Ausgangssignals des Oszillators (5) vorgesehenen Frequenzteilers (9) eingerichtet,
   daß jedes Verzögerungsglied (10) eine unterschiedliche, einer Teilperiode $T = 1/(n * f_{ref})$ des Referenzsignals entsprechende Verzögerungszeit aufweist, wobei n die Anzahl der Zweige (1, 2) und $f_{ref}$ die Frequenz des Referenzsignals ist, und
   daß eine Steuerung (11) zur Freigabe der Frequenzteiler (9) ungefähr nach der Verzögerungszeit des dem jeweiligen Frequenzteiler (9) zugeordneten Verzögerungsgliedes (10) vorgesehen ist.

2. Schaltungsanordnung nach Anspruch 1,
   dadurch gekennzeichnet,
   daß ein Frequenzteiler (6, 9) wenigstens einen Zähler enthält.

3. Schaltungsanordnung nach Anspruch 2,
   dadurch gekennzeichnet,
   daß die Steuerung (11) wenigstens einen Komparator zur Erzeugung eines Freigabesignals für den zugeordneten Frequenzteiler (6, 9) enthält, wenn der Inhalt des Zählers im Frequenzteiler (6, 9) einen vorgebbaren Wert übersteigt.

4. Schaltungsanordnung nach einem der vorhergehenden Ansprüche,
   dadurch gekennzeichnet,
   daß bei zwei Zweigen (1, 2) mit zwei Phasendiskriminatoren (3, 8) die Steuerung (11) zwei D-Kippglieder (13, 14) enthält,
   daß der Takteingang des ersten D-Kippgliedes (13) das Referenzsignal und der Takteingang des zweiten D-Kippgliedes (14) das verzögerte Referenzsignal erhält,
   daß ein Ausgang des ersten D-Kippgliedes (13) mit dem D-Eingang des zweiten D-Kippgliedes (14) gekoppelt ist und daß ein Ausgang des zweiten D-Kippgliedes (14) das Freigabesignal liefert.

5. Schaltungsanordnung nach einem der vorhergehenden Ansprüche,
   dadurch gekennzeichnet,
   daß die Phasendiskriminatoren (3, 8) über einen Wechselschalter (12) mit dem Tiefpaß (4) gekoppelt sind.

6. Schaltungsanordnung nach einem der vorhergehenden Ansprüche,
   dadurch gekennzeichnet,
   daß der Ausgang des Oszillators (5) mit einem Eingang eines Hilfsfrequenzteilers (15) gekoppelt ist, dessen Ausgang mit den Eingängen der Frequenzteiler (6, 9) gekoppelt ist.

FIG.1

FIG.2

FIG.3

FIG.4

FIG.5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| X | US-A-3 571 743 (MENKES E. D.) <br> * Spalte 2, Zeile 63 - Spalte 3, Zeile 31; Abbildungen 3,4 * <br><br>--- | 1-3,5,6 | H03L7/191 <br> H03L7/087 |
| A | US-A-4 888 564 (YUKINOBU ISHIGAKI) <br> * Spalte 7, Zeile 18 - Zeile 37 * <br> * Spalte 8, Zeile 22 - Spalte 10, Zeile 5 * <br> * Spalte 11, Zeile 1 - Zeile 44; Anspruch 1; Abbildungen 5-9 * <br><br>----- | 1-3,5,6 | |
| | | | **RECHERCHIERTE SACHGEBIETE (Int. Cl.5 )** <br><br> H03L |

Der vorliegende Recherchenbericht wurde für alle Patentansprüche erstellt

| Recherchenort | Abschlußdatum der Recherche | Prüfer |
|---|---|---|
| DEN HAAG | 29 SEPTEMBER 1992 | BUTLER N.A. |